# EUROPÄISCHE PATENTSCHRIFT

(11) **EP 2 989 654 B1**
(45) Veröffentlichungstag und Bekanntmachung des Hinweises auf die Patenterteilung: **13.09.2017**
(21) Anmeldenummer: 14731536.0
(22) Anmeldetag: 17.04.2014
(51) Int. Cl.: H01J 37/32, C23C 14/32

(54) **LICHTBOGENVERDAMPFUNGS-BESCHICHTUNGSQUELLE MIT PERMANENTMAGNET**
ARC EVAPORATION COATING SOURCE HAVING A PERMANENT MAGNET
SOURCE DE REVÊTEMENT PAR ÉVAPORATION PAR ARC MUNIE D'UN AIMANT PERMANENT

(30) Priorität: 22.04.2013 AT 1312013 U
(43) Veröffentlichungstag der Anmeldung: 02.03.2016
(73) Patentinhaber: PLANSEE COMPOSITE MATERIALS GMBH, 86983 Lechbruck am See (DE)
(72) Erfinder: PERL, Matthias, A-6675 Tannheim (AT); POLCIK, Peter, A-6600 Reutte (AT); POLZER, Conrad, 71384 Weinstadt (DE); SCHLICHTHERLE, Stefan, A-6632 Ehrwald (AT); STRAUSS, Georg, A-6232 Münster (AT)
(74) Vertreter: Ciesla, Bettina
(86) Internationale Anmeldenummer: PCT/AT2014/000078
(87) Internationale Veröffentlichungsnummer: WO 2014/172722

(56) Entgegenhaltungen:
- WO-A1-2011/127504
- DE-A1- 19 853 943
- JP-A- 2002 212 711
- US-A- 4 622 452
- US-A- 5 298 136
- US-A1- 2004 126 492

## Beschreibung

Die vorliegende Erfindung betrifft eine Lichtbogenverdampfungs-Beschichtungsquelle, die ein Target aus einem zu verdampfenden Beschichtungsmaterial, ein ferromagnetisches Joch zum Beeinflussen der Verdampfung des zu verdampfenden Beschichtungsmaterials und zumindest einem permanentmagnetischen Körper zum Beeinflussen der Verdampfung des zu verdampfenden Beschichtungsmaterials aufweist.

In der Technik werden in großem Umfang Verfahren der physikalischen Dampfphasenabscheidung zur Herstellung verschiedenster Schichten eingesetzt. Die Anwendung reicht von der Herstellung von verschleißfesten und korrosionsbeständigen Beschichtungen für die unterschiedlichsten Substratmaterialien bis hin zur Herstellung geschichteter Materialverbunde, insbesondere in der Halbleiter- und Elektronikindustrie. Aufgrund dieses breiten Anwendungsspektrums müssen verschiedenartige Beschichtungsmaterialien abgeschieden werden.

Bei der physikalischen Dampfphasenabscheidung kommen dabei verschiedene Techniken zum Einsatz, wie z.B. Verdampfen, Kathodenzerstäubung (sputter deposition) oder Lichtbogenverdampfung (cathodic arc deposition bzw. Arc-Source-Verdampfungstechnik).

Bei dem Verfahren der Kathodenzerstäubung wird mittels eines Arbeitsgases, z.B. Argon, ein Plasma in einer Kammer erzeugt. Ionen des Arbeitsgases werden auf ein aus Beschichtungsmaterial gebildetes Target beschleunigt und schlagen dort Teilchen des Beschichtungsmaterials heraus, die in die Dampfphase übertreten und aus dieser auf einem zu beschichtenden Substrat abgeschieden werden. Es ist bekannt, bei dem Verfahren der Kathodenzerstäubung ein Magnetfeld über der aktiven Oberfläche des Targets auszubilden, um den Prozess zu unterstützen. Dabei erhöht das Magnetfeld die Plasmadichte in der Nähe der aktiven Oberfläche des Targets und führt somit zu einem vermehrten Abtrag des Beschichtungsmaterials. Ein derartiges Verfahren wird als Magnetron-Kathodenzerstäubung (magnetron sputter deposition) bezeichnet.

Das Verfahren der Lichtbogenverdampfung unterscheidet sich grundsätzlich von dem zuvor beschriebenen Verfahren der Kathodenzerstäubung. Die Lichtbogenverdampfung kommt unter anderem bei Hartstoffbeschichtungen von Werkzeugen und Maschinenteilen und für Schichten im dekorativen Anwendungsbereich zum Einsatz. Bei der Lichtbogenverdampfung wird eine Bogenentladung ausgenutzt, die zwischen dem als Target bereitgestellten Beschichtungsmaterial als Kathode und einer Anode gezündet wird. Der resultierende Hochstrom-Niederspannungsbogen (im Folgenden Bogen) erzeugt sich selbst über die freien Ladungsträger der Kathode und einen höheren Partialdruck, sodass auch unter Hochvakuum eine Bogenentladung aufrechterhalten werden kann. Je nach Ausgestaltung der verwendeten Technik bewegt sich die Position des Bogens entweder mehr oder weniger zufällig (sogenannte random-arc Technik) oder gesteuert (sogenannte steered-arc Technik) über die Oberfläche der Kathode, wobei auf sehr kleiner Fläche (in sogenannten Spots) ein hoher Energieeintrag in die Oberfläche des Targets erfolgt. Dieser hohe Energieeintrag führt lokal zu einem Verdampfen des Beschichtungsmaterials an der Oberfläche des Targets. Der Bereich eines Spots besteht dabei aus flüssigen Tröpfchen des Beschichtungsmaterials, Beschichtungsmaterialdampf und erzeugten Ionen des Beschichtungsmaterials. Das Target wird nur auf sehr kleinen Flächen in den schmelzflüssigen Zustand übergeführt und kann somit in jeder Lage als Verdampfungsquelle mit relativ hoher Beschichtungsrate betrieben werden. Die Ionisierung des Beschichtungsmaterial-Dampfes ist für die resultierenden Eigenschaften der auf dem zu beschichtenden Substrat abgeschiedenen Schicht aus Beschichtungsmaterial von großer Bedeutung. Bei Beschichtungsmaterialien mit hohem Dampfdruck liegen üblicherweise ca. 25 % der Dampfteilchen in ionisiertem Zustand vor und bei Beschichtungsmaterialien mit niedrigem Dampfdruck üblicherweise zwischen 50 % und 100 % der Dampfteilchen. Für ein reaktives Ionenplattieren sind somit keine zusätzlichen lonisierungsvorrichtungen in der Anlage notwendig. Die grundlegenden Parameter bei der Technik der Lichtbogenverdampfung sind die Bogenspannung und der Bogenstrom, die von weiteren Parametern, wie insbesondere dem Material des Targets, einem vorhandenen Reaktivgas und dem gegebenen Arbeitsdruck, beeinflusst werden. Übliche Betriebsbedingungen bei der Lichtbogenverdampfung sind beispielsweise eine Bogenspannung zwischen 15 V und 30 V und ein Bogenstrom zwischen 50 A und 150 A.

Bei der Lichtbogenverdampfung bestimmt die Geschwindigkeit der Bewegung des Bogens auf der Oberfläche des Targets die Menge des in dem entsprechenden Spot aufgeschmolzenen Materials. Je kleiner diese Geschwindigkeit ist, desto größer ist die zu dem zu beschichtenden Substrat hin geschleuderte Menge an Beschichtungsmaterial aus dem Spot. Eine niedrige Geschwindigkeit führt somit zu unerwünschten Spritzern bzw. Makropartikeln in der auf dem Substrat aufwachsenden Schicht. Die erzielte Geschwindigkeit der Bewegung des Bogens hängt dabei von dem Beschichtungsmaterial des Targets ab. Eine reduzierte elektrische Leitfähigkeit des Beschichtungsmaterials führt zu einer Verringerung der Geschwindigkeit des Bogens. Wenn die Geschwindigkeit des Bogens auf der Oberfläche des Targets zu niedrig ist, d.h. eine zu lange Verweildauer auf einem Spot vorliegt, sind eine lokale thermische Überlastung des Targets und eine starke Verunreinigung der auf dem Substrat aufwachsenden Schicht mit unerwünschten Spritzern bzw. Makropartikeln die Folge. Es kann dabei auch zu einer vorzeitigen Unbrauchbarkeit des Targets aufgrund von makroskopischen Aufschmelzungen der Oberfläche kommen. Insbesondere Werkstoffe mit schlechter Thermoschock-Beständigkeit lassen sich daher bisher kaum bei der Lichtbogenverdampfung einsetzen.

Die Geschwindigkeit der Position des Bogens und somit die Spotgröße können durch Magnetfelder beeinflusst werden. Je höher die Magnetfeldstärke ist, umso schneller bewegt sich der Bogen. Es ist bekannt in Anlagen für die Lichtbogenverdampfung hinter einer gekühlten Auflage für das Target Elektromagneten oder Permanentmagneten vorzusehen, um die Geschwindigkeit des Bogens zu beeinflussen.

WO 2011/127504 A1 (Fig.4, 7) beschreibt eine Beschichtungsquelle für die physikalische Dampfphasenabscheidung mit den Merkmalen des Oberbegriffs von Anspruch 1, insbesondere mit einem pulvermetallurgisch gefertigten Target 2 aus zu verdampfendem Beschichtungsmaterial und zumindest einem in einem pulvermetallurgischen Herstellungsverfahren in das Target eingebrachten und fest mit dem Target verbundenen ferromagnetischen permanentmagnetischen Körper 5, sowie einem an der Rückseite des Targets 2 angeordneten und diese Rückseite topfförmig umgebenden ferromagnetischen Joch 6, wobei der Körper 5 auf einer dem Target 2 zugewandten Seite des ferromagnetischen Jochs 6 in dem Joch aufgenommen ist. Es ist Aufgabe der vorliegenden Erfindung, eine Lichtbogenverdampfungs-Beschichtungsquelle bereitzustellen, die auch bei einem relativ hochschmelzenden Beschichtungsmaterial, keramischem Beschichtungsmaterial mit schlechter Thermoschock-Beständigkeit und bei magnetischem Beschichtungsmaterial einen besonders stabilen Beschichtungsprozess ermöglicht.

Die Aufgabe wird durch eine Lichtbogenverdampfungs-Beschichtungsquelle nach Anspruch 1 gelöst. Vorteilhafte Weiterbildungen sind in den abhängigen Ansprüchen angegeben.

Die Lichtbogenverdampfungs-Beschichtungsquelle weist ein Target aus einem zu verdampfenden Beschichtungsmaterial, ein ferromagnetisches Joch zum Beeinflussen der Verdampfung des zu verdampfenden Beschichtungsmaterials, und zumindest einen permanentmagnetischen Körper zum Beeinflussen der Verdampfung des zu verdampfenden Beschichtungsmaterials auf. Das ferromagnetische Joch ist in Kontakt mit dem Target angeordnet. Der permanentmagnetische Körper ist über das ferromagnetische Joch an dem Target befestigt.

Unter einem Target wird im Rahmen der vorliegenden Beschreibung der Bereich einer Beschichtungsquelle verstanden, der aus dem zu verdampfenden Beschichtungsmaterial gebildet ist. Die Befestigung des permanentmagnetischen Körpers an dem Target über das ferromagnetische Joch ermöglicht es, auch bei hochschmelzenden Materialien als Beschichtungsmaterial, bei keramischem Beschichtungsmaterial mit schlechter Thermoschock-Beständigkeit und bei magnetischem Beschichtungsmaterial durch die Anordnung des ferromagnetischen Jochs in Kontakt mit dem Target einen besonders stabilen Beschichtungsprozess bereitzustellen. Bevorzugt ist auch der permanentmagnetische Körper in direktem Kontakt mit dem Target. Insbesondere kann das Beschichtungsmaterial einen Schmelzpunkt aufweisen, der oberhalb der Curie-Temperatur des Materials des permanentmagnetischen Körpers liegt, und das Target kann pulvermetallurgisch bei relativ hohen Temperaturen hergestellt werden, ohne die permanente Magnetisierung des permanentmagnetischen Körpers zu zerstören, da der permanentmagnetische Körper nachträglich über das ferromagnetische Joch an dem Target befestigt werden kann, was bei einer unmittelbaren pulvermetallurgischen Einbringung des permanentmagnetischen Körpers in das Material des Targets in diesem Fall nicht möglich wäre. Ferner ist eine besonders kompakte Gestaltung der Lichtbogenverdampfungs-Beschichtungsquelle bereitgestellt, bei der das ferromagnetische Joch und der zumindest eine permanentmagnetische Körper in einfacher Weise und kostengünstig sehr nahe an der aktiven Oberfläche des Targets angeordnet werden können. Über die Kombination des ferromagnetischen Jochs mit dem zumindest einen permanentmagnetischen Körper kann ferner das Magnetfeld an der aktiven Oberfläche des Targets sehr zuverlässig vorgegeben werden. Es kann z.B. lediglich ein permanentmagnetischer Körper vorgesehen sein oder die Lichtbogenverdampfungs-Beschichtungsquelle kann z.B. auch mehrere permanentmagnetische Körper aufweisen. Neben dem ferromagnetischen Joch können ferner auch noch weitere ferromagnetische Komponenten oder Bereiche vorgesehen sein. Das ferromagnetische Joch kann bevorzugt einstückig ausgebildet sein, kann aber auch eine Mehrzahl von separaten Elementen aufweisen. Die erfindungsgemäße Ausgestaltung ermöglicht es, auch Lichtbogenverdampfungs-Beschichtungsquellen mit Targets aus keramischen oder metallkeramischen Werkstoffen über z.B. Heißpressen oder sogenanntes Spark Plasma Sintern (SPS) herzustellen, bei welchen Verfahren permanentmagnetische Körper aufgrund der beteiligten hohen Temperaturen ihre Magnetisierung verlieren würden. Mit der erfindungsgemäßen Lichtbogenverdampfungs-Beschichtungsquelle können auch magnetische Werkstoffe im Dauerbetrieb in einer Lichtbogenverdampfungs-Beschichtungsanlage mittels eines Lichtbogens verdampft werden, ohne dass diese eine unerwünschte Rissbildung zeigen. Das ferromagnetische Joch und das Target sind über eine mechanische Verbindung miteinander verbunden. Dadurch wird eine Wiederverwendung des ferromagnetischen Jochs und des permanentmagnetischen Körpers ermöglicht, nachdem das Target verbraucht ist. Die mechanische Verbindung ist erfindungsgemäß eine Gewindeverbindung. Dadurch wird eine besonders einfache und kostengünstige Montage der Lichtbogenverdampfungs-Beschichtungsquelle ermöglicht.

Gemäß einer Weiterbildung ist das Target mit einem Außengewinde versehen, das mit einem an dem Joch vorgesehenen Innengewinde zusammenwirkt. In diesem Fall kann das Target einfach und kostengünstig durch Einschrauben in das Innengewinde des ferromagnetischen Jochs mit dem Joch und dem permanentmagnetischen Körper verbunden werden.

Bevorzugt ist das ferromagnetische Joch an einer Rückseite des Targets angeordnet. Gemäß einer Weiterbildung umgibt das ferromagnetische Joch eine Rückseite des Targets im Wesentlichen topfförmig. In diesem Fall kann das magnetische Feld an der aktiven Oberfläche des Targets besonders zuverlässig eingestellt werden. Insbesondere kann das resultierende magnetische Feld an der aktiven Oberfläche des Targets in diesem Fall durch kleine Veränderungen an der Form des Jochs als auch der Form und Stärke des permanentmagnetischen Körpers in der gewünschten Weise modelliert bzw. verändert werden. Erfindungsgemäß ist der permanentmagnetische Körper auf einer dem Target zugewandten Seite des ferromagnetischen Jochs in dem Joch aufgenommen. Dadurch kann der permanentmagnetische Körper besonders zuverlässig an dem Target befestigt werden und das Magnetfeld des permanentmagnetischen Körpers kann dabei in der gewünschten Weise durch das Joch modelliert werden.

Gemäß einer Weiterbildung ist der permanentmagnetische Körper ringförmig ausgebildet. In diesem Fall ist eine besonders symmetrische Ausbildung des Magnetfelds an der aktiven Oberfläche des Targets ermöglicht. Je nach Form des Targets kann der permanentmagnetische Körper dabei z.B. eine im Wesentlichen kreisförmige Ringform, eine im Wesentlichen ovale Ringform oder auch eine eckige Ringform aufweisen.

Gemäß einer Weiterbildung weist das Joch einen Verbindungsabschnitt zur mechanischen Befestigung an einer gekühlten Auflage einer Lichtbogenverdampfungs-Beschichtungsanlage auf. In diesem Fall kann die Lichtbogenverdampfungs-Beschichtungsquelle sehr platzsparend ohne weitere Komponenten in der Beschichtungsanlage befestigt werden. Gemäß einer Weiterbildung weist der Verbindungsabschnitt ein Gewinde auf. Je nach Ausgestaltung der Beschichtungsanlage kann das Gewinde z.B. als ein Innengewinde zum Zusammenwirken mit einem Außengewinde der Beschichtungsanlage oder z.B. als ein Außengewinde zum Zusammenwirken mit einem Innengewinde der Beschichtungsanlage ausgebildet sein.

Weitere Vorteile und Zweckmäßigkeiten der Erfindung ergeben sich anhand der nachfolgenden Beschreibung von Ausführungsbeispielen unter Bezugnahme auf die beigefügten Figuren.

Von den Figuren zeigen:
- Fig. 1:: eine schematische Aufsicht auf eine Lichtbogenverdampfungs-Beschichtungsquelle gemäß einer Ausführungsform;
- Fig. 2:: eine schematische Schnittdarstellung der Lichtbogenverdampfungs-Beschichtungsquelle von Fig. 1;
- Fig. 3:: eine schematische Explosions-Schnittdarstellung zur Erläuterung der einzelnen Komponenten der Lichtbogenverdampfungs-Beschichtungsquelle;
- Fig. 4:: eine schematische Explosions-Schnittdarstellung einer Lichtbogenverdampfungs-Beschichtungsquelle gemäß einer ersten Abwandlung;
- Fig. 5:: eine schematische Explosions-Schnittdarstellung einer Lichtbogenverdampfungs-Beschichtungsquelle gemäß einer zweiten Abwandlung und
- Fig. 6:: eine schematische Explosions-Schnittdarstellung einer Lichtbogenverdampfungs-Beschichtungsquelle gemäß einer weiteren Abwandlung.

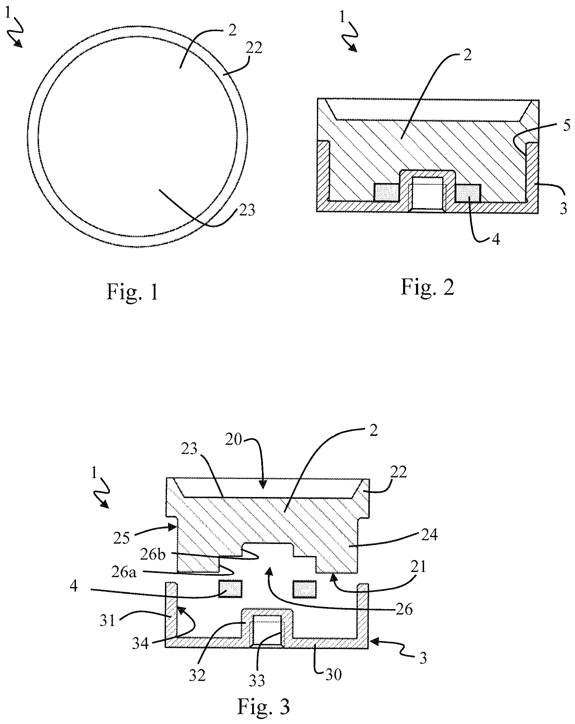

Eine Ausführungsform wird im Folgenden unter Bezug auf die Fig. 1 und Fig. 2 eingehender beschrieben, wobei unter Bezug auf die Fig. 3 bis Fig. 6 dabei auch mögliche Abwandlungen mitbeschrieben werden und für die entsprechenden Komponenten jeweils dieselben Bezugszeichen verwendet werden.

Die Lichtbogenverdampfungs-Beschichtungsquelle 1 weist bei der ersten Ausführungsform in Aufsicht eine im Wesentlichen runde Form auf, wie in Fig. 1 zu sehen ist. Obwohl in Bezug auf das Ausführungsbeispiel und dessen Abwandlungen jeweils Lichtbogenverdampfungs-Beschichtungsquellen 1 mit im Wesentlichen runder Form beschrieben werden, sind auch andere Formen möglich, insbesondere auch ovale oder länglich rechteckige Formen.

Die Lichtbogenverdampfungs-Beschichtungsquelle 1 weist ein Target 2 auf, das aus dem zu verdampfenden Beschichtungsmaterial besteht. Bei dem dargestellten Ausführungsbeispiel weist das Target 2 eine im Wesentlichen zylindrische Form mit einer Stirnseite 20 und einer Rückseite 21 auf. Die Stirnseite 20 ist als eine aktive Oberfläche ausgebildet, auf der sich im Betrieb der Lichtbogenverdampfungs-Beschichtungsquelle 1 in einer Lichtbogenverdampfungs-Beschichtungsanlage der Lichtbogen bewegt und die Verdampfung des Beschichtungsmaterials erfolgt. Die Stirnseite 20 weist eine im Wesentlichen ebene Fläche 23 auf, die von einem umlaufenden Rand 22 umgeben ist, der an der Stirnseite 20 von der ebenen Fläche 23 hervorsteht. Auf der Außenseite ist der Rand 22 von einer im Wesentlichen zylindrischen Fläche begrenzt. Der Rand 22 weist einen Innendurchmesser auf, der sich ausgehend von der ebenen Fläche 23 leicht aufweitet, sodass der Rand 22 sich mit zunehmendem Abstand von der ebenen Fläche 23 verjüngt.

Obwohl bei dem Ausführungsbeispiel eine Ausgestaltung gezeigt ist, bei der das Target 2 den zuvor beschriebenen Rand 22 aufweist, ist es z.B. auch möglich, dass das Target 2 eine vollkommen flache Stirnseite 20 ohne einen solchen Rand 22 aufweist. Es sind auch noch weitere abweichende Ausgestaltungen der Stirnseite 20 möglich.

Rückseitig des im Wesentlichen zylindrischen Außendurchmessers des Randes 22 ist das Target 2 in einem an die Rückseite 21 anschließenden Bereich 24 mit einem Außendurchmesser versehen, der etwas kleiner als der Außendurchmesser im Bereich des Randes 22 ist, sodass in der Außenseite des Targets 2 eine umlaufende Stufe ausgebildet ist.

In dem an die Rückseite 21 anschließenden Bereich 24 weist das Target 2 bei der Ausführungsform ebenfalls einen im Wesentlichen zylindrischen Außendurchmesser auf. In diesem Bereich 24 ist das Target 2 mit einem Außengewinde 25 versehen, dessen Funktion anschließend noch eingehender beschrieben wird.

In der Rückseite 21 ist in einem zentralen Bereich eine Ausnehmung 26 ausgebildet, die bei dem dargestellten Ausführungsbeispiel eine zweistufige Ausgestaltung mit einem ersten Abschnitt 26a mit einem größeren Querschnitt und einem daran anschließenden zweiten Abschnitt 26b mit einem kleineren Querschnitt aufweist. Obwohl bei dem Ausführungsbeispiel eine solche zweistufige Ausgestaltung gezeigt ist, sind auch andere Ausgestaltungen möglich, z.B. kann die Ausnehmung 26 auch als einfache Vertiefung mit nur einem ersten Abschnitt ausgebildet sein.

Das Target 2 kann insbesondere in einem pulvermetallurgischen Herstellungsverfahren aus einem oder mehreren Ausgangspulvern durch Kompaktieren in einer Presse und anschließendes Sintern hergestellt werden, wobei das oder die Ausgangspulver insbesondere auch ein oder mehrere Komponenten mit einem sehr hohen Schmelzpunkt aufweisen kann bzw. können. Das Target 2 kann dabei insbesondere auch aus einem metallkeramischen oder keramischen Material als Beschichtungsmaterial ausgebildet sein.

Bei dem dargestellten Ausführungsbeispiel kann das Außengewinde 25 z.B. direkt bei dem pulvermetallurgischen Herstellungsprozess in das Beschichtungsmaterial eingebracht werden, z.B. durch Pressen in die entsprechende Form oder durch mechanische Bearbeitung des Grünlings vor dem Sintern, oder aber das Außengewinde 25 kann nach dem Sintern durch mechanische Bearbeitung erzeugt werden.

Wie insbesondere in den Fig. 2 und Fig. 3 zu sehen ist, weist die Lichtbogenverdampfungs-Beschichtungsquelle 1 ferner ein ferromagnetisches Joch 3 auf, dass bei dem Ausführungsbeispiel z.B. durch Stahl gebildet sein kann. Es sind z.B. jedoch auch andere ferromagnetische Materialien möglich. Das ferromagnetische Joch 3 weist eine topfförmige Form mit einem Bodenbereich 30 und einer sich von dem Bodenbereich 30 umlaufend nach oben, d.h. in Richtung der aktiven Oberfläche des Targets 2, erstreckenden Seitenwand 31 auf. In einem zentralen Abschnitt ist der Bodenbereich 30 mit einem Vorsprung 32 versehen, der sich ausgehend von dem Bodenbereich 30 in Richtung des Targets 2 erstreckt. Auf der dem Target 2 zugewandten Seite weist der Bodenbereich 30 somit eine den Vorsprung 32 umgebende im Wesentlichen ringförmige Fläche auf.

Das ferromagnetische Joch 3 ist mit einem Verbindungsabschnitt zur mechanischen Befestigung an einer gekühlten Auflage einer Lichtbogenverdampfungs-Beschichtungsanlage versehen. Bei dem Ausführungsbeispiel ist in dem Vorsprung 32 ausgehend von der Rückseite des ferromagnetischen Jochs 3 ein Innengewinde 33 ausgebildet ist, das dazu angepasst ist, mit einem entsprechenden Außengewinde an einer gekühlten Auflage der Lichtbogenverdampfungs-Beschichtungsanlage zusammenzuwirken. Obwohl bei dem Ausführungsbeispiel an dem Joch ein solches Innengewinde 33 vorgesehen ist, ist es z.B. auch möglich an dem ferromagnetischen Joch 3 einen anders ausgebildeten Verbindungsabschnitt vorzusehen, z.B. einen von der Rückseite vorstehenden Vorsprung mit einem Außengewinde.

Das ferromagnetische Joch 3 weist ein Innengewinde 34 auf, das dazu ausgebildet ist, mit dem Außengewinde 25 des Targets 2 unter Ausbildung einer Gewindeverbindung zusammenzuwirken. Wie insbesondere in Fig. 2 zu sehen ist, sind das ferromagnetische Joch 3 und das Target 2 somit über eine mechanische Verbindung 5 miteinander verbunden, die bei dem dargestellten Ausführungsbeispiel durch die Gewindeverbindung gebildet ist. Wie in Fig. 2 zu sehen ist, ist der Außendurchmesser der Seitenwand 31 des ferromagnetischen Jochs 3 derart bemessen, dass er dem Außendurchmesser des Targets 2 im Bereich der aktiven Oberfläche entspricht, sodass dass ferromagnetische Joch 3 im zusammengeschraubten Zustand bündig an das Target 2 anschließt. Die Lichtbogenverdampfungs-Beschichtungsquelle 1 weist ferner noch zumindest einen permanentmagnetischen Körper 4 auf. Bei dem Ausführungsbeispiel ist der permanentmagnetische Körper 4 durch einen Ring gebildet, der vor dem Ausbilden der mechanischen Verbindung zwischen dem ferromagnetischen Joch 3 und dem Target 2 in das ferromagnetische Joch 3 eingelegt wird. Bei dem Ausführungsbeispiel ist der permanentmagnetische Körper 4 derart ausgelegt, dass er so in das ferromagnetische Joch 3 eingelegt werden kann, dass er den Vorsprung 32 am Bodenbereich 30 des ferromagnetischen Jochs 3 im Wesentlichen ringförmig umgibt und durch den Vorsprung 32 zentriert gehalten wird.

Der Außenumfang des permanentmagnetischen Körpers 4 und die Ausnehmung 26 in dem Target 2 sind derart aufeinander angepasst, dass der permanentmagnetische Körper 4 in der Ausnehmung 26 aufgenommen wird. Bei dem dargestellten Ausführungsbeispiel wird der permanentmagnetische Körper 4 in dem ersten Abschnitt 26a der Ausnehmung 26 aufgenommen und der Vorsprung 32 erstreckt sich bis in den zweiten Abschnitt 26b der Ausnehmung 26. Obwohl bei dem Ausführungsbeispiel nur ein permanentmagnetischer Körper 4 dargestellt ist, kann auch eine Mehrzahl von permanentmagnetischen Körpern 4 vorgesehen sein. Ferner können die permanentmagnetischen Körper 4 auch eine andere Form aufweisen.

Wie insbesondere in Fig. 2 zu sehen ist, sind das Target 2, das ferromagnetische Joch 3 und der permanentmagnetische Körper 4 derart in der Form aufeinander abgestimmt, dass in einem zusammengesetzten Zustand der Lichtbogenverdampfungs-Beschichtungsquelle 1 das Target 2, das ferromagnetische Joch 3 und der permanentmagnetische Körper 4 fest aneinander anliegen. Folglich weist die Lichtbogenverdampfungs-Beschichtungsquelle 1 einen sehr kompakten Aufbau auf.

Um eine möglichst gute elektrische und thermische Kontaktierung zwischen der Rückseite 21 des Targets 2 und dem Bodenbereich 30 des ferromagnetischen Jochs 3 bereitzustellen, kann ferner zwischen dem Target 2 und dem Bodenbereich 30 des ferromagnetischen Jochs 3 eine Folie aus einem Material mit hoher elektrischer und thermischer Leitfähigkeit angeordnet werden, die bei dem Ausbilden der mechanischen Verbindung zwischen dem Target 2 und dem ferromagnetischen Joch 3 zwischen diesen eingeklemmt wird, z.B. eine dünne Graphitfolie. Die Folie kann dabei insbesondere eine im Wesentlichen ringförmige Form aufweisen, die an den ringförmigen Bodenbereich 30 um den Vorsprung 32 herum angepasst ist.

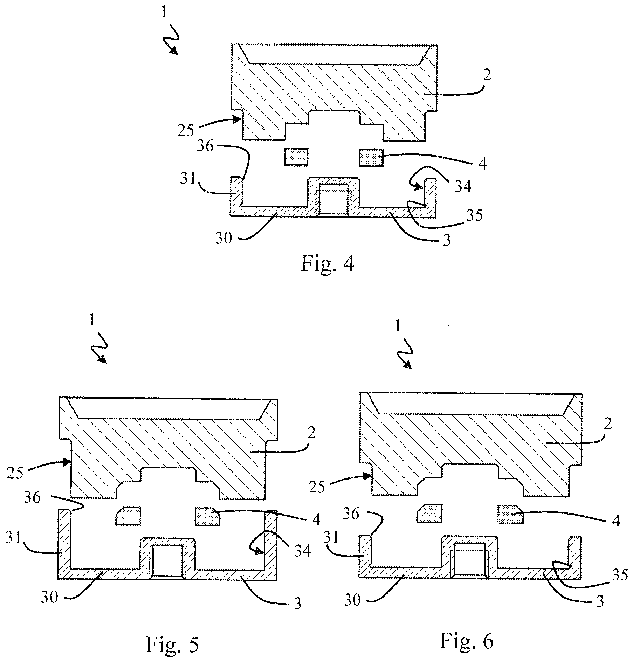

Bei der beschriebenen Lichtbogenverdampfungs-Beschichtungsquelle 1 kann das resultierende Magnetfeld an der aktiven Oberfläche des Targets 2 durch leichte geometrische Anpassungen der Form des Targets 2, des ferromagnetischen Jochs 3 und/oder des permanentmagnetischen Körpers 4 in einfacher Weise verändert bzw. angepasst werden, wie in den Fig. 4 bis Fig. 6 schematisch dargestellt ist.

Wie in Fig. 4 schematisch dargestellt ist, kann zur Veränderung des resultierenden Magnetfelds die Höhe der Seitenwand 31 des ferromagnetischen Jochs 3 verändert werden. Ferner kann zur Veränderung des resultierenden Magnetfelds auch die Wandstärke der Seitenwand 31 des ferromagnetischen Jochs 3 verändert werden.

Wie in Fig. 4 weiter zu sehen ist, kann an der Innenseite der Seitenwand 31 unterhalb des Innengewindes 34 bevorzugt ein Freistich 35 vorgesehen sein.

Wie in Fig. 4 zu sehen ist, weist das freie Ende der Seitenwand 31 des ferromagnetischen Jochs auf der Innenseite eine abgerundete Ausgestaltung mit einem vorgegebenen Krümmungsradius 36 auf. Durch eine Vergrößerung oder Verkleinerung des Krümmungsradius 36 kann ebenfalls das resultierende Magnetfeld wesentlich beeinflusst werden.

Wie in den Fig. 5 und Fig. 6 schematisch dargestellt ist, kann ferner die Form des permanentmagnetischen Körpers 4 verändert werden, um das resultierende Magnetfeld zu verändern. In den Fig. 5 und 6 weist der ferromagnetische Körper 4 ebenfalls eine im Wesentlichen ringförmige Form auf, wobei allerdings auf der dem Target 2 zugewandten Seite der Außenumfang des ferromagnetischen Körpers 4 etwas abgeflacht bzw. abgerundet ausgebildet ist. Insbesondere können die beschriebenen Möglichkeiten der Veränderung der geometrischen Formen der Seitenwand 31 des ferromagnetischen Jochs 3 und des permanentmagnetischen Körpers 4 miteinander kombiniert werden, um ein gewünschtes resultierendes Magnetfeld bereitzustellen.

Gemäß einer Weiterbildung kann die beschriebene Lichtbogenverdampfungs-Beschichtungsquelle 1 auch z.B. durch Hintergießen mit einem Material mit hoher thermischer Leitfähigkeit, wie z.B. Cu oder einer Cu-Legierung, noch besser thermisch an die gekühlte Auflage einer Lichtbogenverdampfungs-Beschichtungsanlage angekoppelt werden, sodass auch Beschichtungsmaterialien mit sehr niedriger Thermoschockbeständigkeit in einer Lichtbogenverdampfungs-Beschichtungsanlage mittels eines Lichtbogens verdampft werden können.

Es wurde somit eine Ausführungsform beschrieben, mit der es ermöglicht ist, eine sehr hohe Magnetfelddichte an der Oberfläche des Targets einer Lichtbogenverdampfungs-Beschichtungsquelle bereitzustellen. Bei der Lichtbogenverdampfung werden in dieser Weise die Zündeigenschaften und die Stabilität des Bogens während eines Beschichtungsprozesses wesentlich verbessert. Bei metallischen Targets wird in dieser Weise eine Reduktion der Emission von Spritzern und Tröpfchen erreicht. Bei Targets aus metallkeramischem Material bzw. keramischem Material werden aufgrund der höheren erzielten Geschwindigkeit in der Bewegung des Lichtbogens und der Möglichkeit, die Bewegung und damit den Abtrag des Beschichtungsmaterials in gewünschte Bahnen zu lenken, der lokale Energieeintrag im Spot verringert und Nachteile aufgrund von niedriger elektrischer Leitfähigkeit und niedriger Thermoschockbeständigkeit des Beschichtungsmaterials kompensiert. Das ferromagnetische Joch 3 und der zumindest eine permanentmagnetische Körper 4 können dabei derart angeordnet werden, dass der Abtragvorgang bzw. das Abtragprofil des Beschichtungsmaterials gesteuert werden können. Es wird ferner auch eine direkte Abscheidung ferromagnetischer Beschichtungsmaterialien mittels Lichtbogenverdampfung ermöglicht.

Das ferromagnetische Joch 3 und der zumindest eine permanentmagnetische Bereich 4 können z.B. darauf optimiert werden, dass im Zusammenspiel mit in der Beschichtungsanlage vorgesehenen externen Magnetfeldern im oberflächennahen Bereich des Targets die gewünschten Magnetfelder mit hoher Genauigkeit eingestellt werden. Es kann dabei eine gezielte Schwächung und/oder Verstärkung anlagenseitiger Magnetfelder mit lokaler Auflösung bereitgestellt werden. Die magnetischen Bereiche können dabei z.B. auch derart ausgebildet werden, dass bestimmte Bereiche für den Beschichtungsprozess abgeschirmt werden, sodass dort kein nennenswerter Abtrag stattfindet. Ferner können durch die beschriebene Ausgestaltung bestimmte Bereiche des Targets vor Vergiftung geschützt werden, indem z.B. durch gezielte Gestaltung der resultierenden Magnetfelder eine unerwünschte Beschichtung des Targets mit z.B. keramischen Nitrid- oder Oxidschichten vermieden wird. Es können die Bewegungsbahnen des Bogens an der aktiven Oberfläche des Targets vorgegeben werden. Dies ermöglicht z.B. die Verwendung segmentierter Targets, die entweder durch ihre Herstelltechnologie bedingt nur in kleinen Abmessungen herstellbar sind oder die in verschiedenen Bereichen unterschiedliche Materialzusammensetzungen aufweisen, zum Abscheiden von Schichten mit gewünschter chemischer Zusammensetzung.

## Patentansprüche

1. Lichtbogenverdampfungs-Beschichtungsquelle (1) mit:
einem Target (2) aus einem zu verdampfenden Beschichtungsmaterial,
einem ferromagnetischen Joch (3) zum Beeinflussen der Verdampfung des zu verdampfenden Beschichtungsmaterials, und
zumindest einem permanentmagnetischen Körper (4) zum Beeinflussen der Verdampfung des zu verdampfenden Beschichtungsmaterials,
wobei das ferromagnetische Joch (3) in Kontakt mit dem Target (2) angeordnet ist,
wobei der permanentmagnetische Körper (4) über das ferromagnetische Joch (3) an dem Target (2) befestigt ist, und wobei der permanentmagnetische Körper (4) auf einer dem Target (2) zugewandten Seite des ferromagnetischen Jochs (3) in dem Joch (3) aufgenommen ist, **dadurch gekennzeichnet, dass** das das ferromagnetische Joch (3) und das Target (2) über eine Gewindeverbindung miteinander verbunden sind.

2. Lichtbogenverdampfungs-Beschichtungsquelle nach Anspruch 1, wobei das Target (2) mit einem Außengewinde (25) versehen ist, das mit einem an dem Joch (3) vorgesehenen Innengewinde (34) zusammenwirkt.

3. Lichtbogenverdampfungs-Beschichtungsquelle nach einem der vorangehenden Ansprüche, wobei das ferromagnetische Joch (3) an einer Rückseite (21) des Targets (2) angeordnet ist.

4. Lichtbogenverdampfungs-Beschichtungsquelle nach einem der vorangehenden Ansprüche, wobei das ferromagnetische Joch (3) eine Rückseite (21) des Targets (2) im Wesentlichen topfförmig umgibt.

5. Lichtbogenverdampfungs-Beschichtungsquelle nach einem der vorangehenden Ansprüche, wobei der permanentmagnetische Körper (4) ringförmig ausgebildet ist.

6. Lichtbogenverdampfungs-Beschichtungsquelle nach einem der vorangehenden Ansprüche, wobei das Joch (3) einen Verbindungsabschnitt (33) zur mechanischen Befestigung an einer gekühlten Auflage einer Lichtbogenverdampfungs-Beschichtungsanlage aufweist.

7. Lichtbogenverdampfungs-Beschichtungsquelle nach Anspruch 6, wobei der Verbindungsabschnitt (33) ein Gewinde aufweist.

## Claims

1. An arc evaporation coating source (1) comprising:
a target (2) of a coating material to be evaporated,
a ferromagnetic yoke (3) for influencing the evaporisation of the coating material to be evaporated, and
at least one permanent-magnetic body (4) for influencing the evaporation of the coating material to be evaporated,
the ferromagnetic yoke (3) being arranged in contact with the target (2), the permanent-magnetic body (4) being fastened to the target (2) by way of the ferromagnetic yoke (3),
the permanent-magnetic body (4) being accommodated in the ferromagnetic yoke (3) on a side of the yoke (3) that is facing the target (2),
**characterized in that** the ferromagnetic yoke (3) and the target (2) being connected to one another by way of a threaded connection.

2. The arc evaporation coating source as claimed in claim 1, the target (2) being provided with an external thread (25), which interacts with an internal thread (34) provided on the yoke (3).

3. The arc evaporation coating source as claimed in one of the preceding claims, the ferromagnetic yoke (3) being arranged on a rear side (21) of the target (2).

4. The arc evaporation coating source as claimed in one of the preceding claims, the ferromagnetic yoke (3) surrounding a rear side (21) of the target (2) substantially in the form of a pot.

5. The arc evaporation coating source as claimed in one of the preceding claims, the permanent-magnetic body (4) being formed ring-shaped.

6. The arc evaporation coating source as claimed in one of the preceding claims, the yoke (3) having a connecting portion (33) for the mechanical fastening to a cooled support of an arc evaporation coating facility.

7. The arc evaporation coating source as claimed in claim 6, the connecting portion (33) having a thread.

## Revendications

1. Source de revêtement à évaporation par arc (1), comportant :
une cible (2) constituée d'un matériau de revêtement à évaporer,
une culasse ferromagnétique (3) destinée à agir sur l'évaporation du matériau de revêtement à évaporer, et au moins un corps à aimantation permanente (4) destiné à agir sur l'évaporation du matériau de revêtement à évaporer,
dans laquelle la culasse ferromagnétique (3) est disposée au contact de la cible (2),
dans laquelle le corps à aimantation permanente (4) est fixé par l'intermédiaire de la culasse magnétique (3) à la cible (2), et
dans laquelle le corps à aimantation permanente (4) est reçu dans la culasse (3) sur un côté de la culasse ferromagnétique (3) qui est tourné vers la cible (2),
**caractérisée en ce que** la culasse ferromagnétique (3) et la cible (2) sont reliées l'une à l'autre par l'intermédiaire d'une liaison filetée.

2. Source de revêtement à évaporation par arc selon la revendication 1, dans laquelle la cible (2) est munie d'un filetage extérieur (25) qui coopère avec un filetage intérieur (34) prévu sur la culasse (3).

3. Source de revêtement à évaporation par arc selon l'une quelconque des revendications précédentes, dans laquelle la culasse ferromagnétique (3) est disposée sur une face arrière (21) de la cible (2).

4. Source de revêtement à évaporation par arc selon l'une quelconque des revendications précédentes, dans laquelle la culasse ferromagnétique (3) entoure sensiblement à la manière d'un pot une face arrière (21) de la cible (2).

5. Source de revêtement à évaporation par arc selon l'une quelconque des revendications précédentes, dans laquelle le corps à aimantation permanente (4) est réalisé sous forme annulaire.

6. Source de revêtement à évaporation par arc selon l'une quelconque des revendications précédentes, dans laquelle la culasse (3) présente une partie de liaison (33) permettant sa fixation mécanique à un revêtement refroidi d'une installation de revêtement à évaporation par arc.

7. Source de revêtement à évaporation par arc selon la revendication 6, dans laquelle la partie de liaison (33) présente un filetage.
